# EUROPEAN PATENT APPLICATION

(11) **EP 2 402 769 A1**
(43) Date of publication of application: **04.01.2012**
(21) Application number: 10006744.6
(22) Date of filing: 30.06.2010
(51) Int. Cl.: G01R 15/14, H01F 38/34, H02H 1/00, G01R 15/18, G01R 15/04

(54) **Combined detection device for electrical variables**

(71) Applicant: ABB Technology AG, 8050 Zürich (CH)
(72) Inventor: Javora, Radek, 62400 Brno (CZ); Podzemny, Jaromir, 62100 Brno (CZ)
(74) Representative: Kania, Frantisek

(57) **Abstract**

A combined electrical variable detection device comprises a number of single-phase current measuring modules (1) arranged In a common frame (2) and has a separate output cable/connection (8) for each module (1). At least one single-phase current measuring module (1) is provided with a voltage detection device. It further uses one output cable/connection (7), the signal wires of which are coupled to said output cable/connections (8) from said modules (1). Preferably all single-phase current measuring modules (1) are provided with Rogowski coils as measuring elements. The combined electrical variable detection device can be provided with a residual-current detection device (3) an/or a residual-voltage detection device surrounding more than one of said single-phase current measuring modules (1) in said common frame (2). Voltage detection devices Preferably contain resistive or capacitive dividers for voltage detection.The invention gives a solution for a combined electrical variable detection device not only for measuring a current in preferably three single phases, but for a voltage measurement in at least one single phase at the same time, as well as for a residual current and voltage measurement possibility, all this being achievable by using a low size measurement modules In a common frame with a possibility of an easy connection of the whole combined electrical variable detection device to the output measuring and control units.

## Description

### Field of the invention

The invention concerns a combined electrical variable detection device, containing a number of single-phase current measuring modules arranged in a common frame, having a separate output cable/connection for each module.

### Prior Art

In medium voltage switchgears, there is a need to use instrument current and voltage transformers in order to:
Reduce current and voltage values of the plant or substation down to the values such as to be able to be detected by measurement and protection apparatus.
Make the secondary measurement and protection circuits galvanically independent of the primary power circuit, at the same time guaranteeing greater safety for operators.

A current and voltage detection/measurement in medium voltage networks is usually done by means of separate devices on each phase. For protection purposes, separate devices for residual current measurement and/or residual voltage measurement are needed as well.

A residual current transformer, also known as a zero sequence current transformer, is used for detection of earth leakage and earth fault protection. In such transformer, the three phases (cables or busbars) of a three phase system pass through the inner diameter of the current transformer. When the system is fault free, no current flows in the secondary winding of the residual current transformer. When there is an earth fault, the residual current or a zero sequence current of the system flows through the secondary winding of the residual current transformer and this operates the connected relay.

The three voltages of a balanced system summate to zero, but this is not the case if the system is subject to a single-phase earth fault The residual voltage which exists in this case is significant in protective switchgear practice as a means of detecting earth fault conditions. The residual voltage of a system is measured by connecting the primary windings of a three single-phase voltage transformers in phase-to-ground connection and connecting the secondary windings in series or "open delta". The output of the secondary windings connected in "open delta" is zero when balanced sinusoidal voltages are applied, but under conditions of imbalance a residual voltage of the system will be developed. The residual voltage is three times the zero sequence voltage.

Usually, all these devices described above are separate devices, which need to be fixed somewhere inside of the system in order to ensure proper position of primary conductors and mechanical stability of all components. Usually inductive instrument transformers are used for this purpose, nevertheless electronic instrument transformers, sometimes called also non-conventional instrument transformers or sensors, can also be used in order to fulfill the same needs.

In case of inductive current transformers, it is quite difficult to produce one unit having three single-phase transformers in one body. If it is done, solution could be quite bulky and heavy especially for protection purposes, where big dynamic range is required. Furthermore, one can place three single phase transformers/coils into one body in order to have a compact solution, but residual current measurement needs a separate device today.

Due to a presence of a ferromagnetic core in classical current transformers and resulting size and weight of the full solution, it is not so advantageous to combine together phase current measurements and even more the residual current measurement. Furthermore, the presence of the ferromagnetic core influences the magnetic field and a combination of several ferromagnetic cores, each designed for different rated primary currents, may affect the total magnetic field, It may cause higher non-liner behavior which then makes it more difficult to reach a required accuracy for each measurement.

Electronic current transformers or sensors are also used in the same way, but their use for residual current measurement is not so common in medium voltage applications and current transformers are rather used.

To be able to calculate an output power, one needs to measure both electric current and electric voltage. Both these measurements are necessary for some protection functions as well. A limiting factor for implementing of all necessary measuring elements in such case could be the space within medium voltage switchgears. New switchgear designs are being designed smaller and with challenging parameters, thus requiring smaller and compact measuring solutions, hardly achievable by conventional technologies of instrument transformers today.

It is the aim of this invention to propose a solution for a combined electrical variable detection device not only for measuring a current in preferably three single phases, but for measuring a voltage in at least one single phase at the same time, as well as including residual current and voltage measurement possibility.

Another aim is to arrange low size measurement modules in a common frame, the measurement modules having a separate output cable/connection for each module, and to propose an easy connection of the whole combined electrical variable detection device to the output measuring and control units.

### Summary of the invention

The aim of this invention has been achieved by a combined electrical variable detection device, consisting of a number of single-phase current measuring modules arranged in a common frame, having a separate output cable/connection for each module, the invention consisting in that at least one single-phase current measuring module is provided with a voltage detection device, the combined electrical variable detection device using one output cable/connection, the signal wires of which are coupled to said output cable/connections from said modules. Preferably all single-phase current measuring modules, e.g. based on Rogowski coil principle, are provided with a voltage detection device.

In one preferred embodiment of this invention the combined electrical variable detection device is provided with a residual-current detection device surrounding more than one of said single-phase current measuring modules (1) in said common frame.

In an even more preferred embodiment of this invention the combined electrical variable detection device combines three phase-current measuring modules, each of which is provided with the corresponding phase-voltage detection device, all phase-current measuring modules and phase-voltage detection devices being placed together with a residual-current detection device in said common frame and all the devices and modules being positioned close to each other.

Another preferred feature of this invention is that at least one of the phase-current measuring modules is/are fixed in said common frame, said common frame being designed for embedding of more phase-current measuring modules than the number that is/are actually fixed. Yet another preferred feature of this invention is that voltage detection devices contain resistive or capacitive dividers for voltage detection.

In many cases it is advantageous to provide the device with other sensing elements as a temperature measuring device or even with a residual-voltage detection device.

### Brief description of the drawings

The invention will be more in detail described according to the enclosed drawings, where
- Fig. 1 shows an exploded view of a combined electrical variable detection device containing three single-phase current measuring modules that are provided with a voltage detection device and that are arranged in a common frame.
- Fig. 2 shows a combined electrical variable detection device as shown in Fig. 1 further containing a temperature measurement device and one output cable and
- Fig. 3 shows a cross-section of one single-phase module containing single-phase current and voltage detection units.

### Detailed Description of the Invention

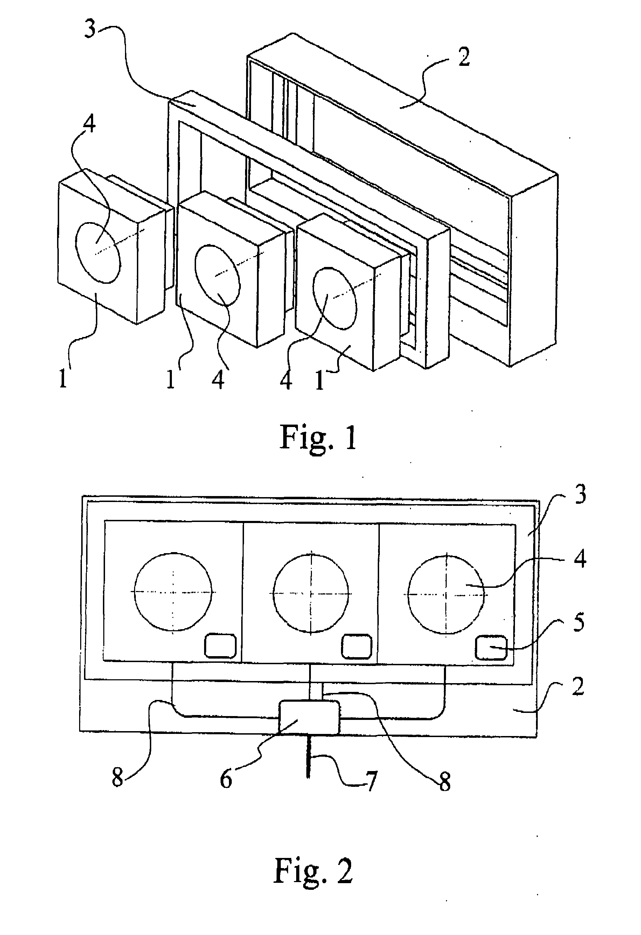

Fig. 1 shows an exploded view of a combined electrical variable detection device. The combined electrical variable detection device contains three single-phase current and voltage measuring modules 1 that are arranged in a common frame 2. In the same common frame 2 is arranged a residual-current detection device 3 that surrounds all three single-phase current and voltage measuring modules 1. The current is measured preferably by a Rogowski coil that measures magnetic field, caused by a current flowing through one phase conductor inserted into an opening 4 in one single-phase current and voltage measuring module 1. The Rogowski coil is placed around that phase conductor in the single-phase current and voltage measuring module 1. Three Rogowski coils are used in order to provide information about all three phases usually needed to be measured. These coils may have a toroidal or oval shape. Rogowski coil is used also for residual current measurement provided by the residual-current detection device 3. This coil could have basically also a toroidal shape, but that would result in too big product/space occupied. Therefore, oval or rectangular shape seems to be the best fit for such products. The residual-current detection device 3 is surrounding the three single-phase current and voltage measuring modules 1 and placed on top of them in order to make the combined electrical variable detection device body very thin. Rogowski coils do not use any ferromagnetic core, so no influence of magnetic material nonlinearity from all three phases should be introduced to residual current measurement nor the phase current measurements should be influenced. Each single-phase current and voltage measuring module 1 is provided with a single-phase voltage measuring sensor made of resistive or capacitive voltage divider. The voltage divider may also need some shielding electrodes to provide proper electric field distribution.

Fig. 2 shows a combined electrical variable detection device containing an aptional temperature measurement device 5 and one connector 6 with one output cable 7. To this output connector 6 all internal wires 8 are coupled. Cast-in cable could be used instead of such connector 6 as well as secondary terminals as usually used in case of instrument transformers. Though the embodiment of Fig. 2 shows the temperature measurement device 5 as a part of the combined electrical variable detection device, it is clear that embodiments where this temperature measurement device 5 is missing can be used as well and clearly fall within the scope of this invention. If all Rogowski coils are equipped with conductive or semiconductive layer on top of each other, possible stray/parasitic influences will be minimized.

All Rogowski coils are embedded in the single-phase current and voltage measuring modules 1 and the residual-current detection device 3 are placed in the same body/case, i.e. in the same common frame 2. This common frame 2 with the single-phase current and voltage measuring modules 1 and the residual-current detection device 3 has openings 4 for entry of the primary conductors of each phase. Openings 4 could be made oval in order to accommodate flat-type of busbars or they can have also circular shape fitting better to rounded primary conductors. Common frame 2 is also equipped with means for mechanical fixations in order to ensure proper positioning of the device and to avoid mechanical damage.

Proposed solution uses the possibility of introducing a modular concept. The single-phase current and voltage measuring modules 1 use Rogowski coils as single-phase current sensors. These three single-phase current and voltage measuring modules 1 are placed and fixed in one common frame 2. The same common frame 2 can be also able to accommodate residual current detection device 3. This residual current detection device 3 can be placed into the common frame 2 from the same side as proposed in Fig. 1, or from the other side of the common frame 2. Fixing can be done by filling the cavity in the common frame 2 using some filling material, e.g. epoxy or polyurethane. Nevertheless, residual current detection device 3 can be also produced as a module, in the same way as single-phase current and voltage measuring modules 1, and be then placed/fixed to the common frame 2 in a similar manner as single-phase current and voltage measuring modules 1. Due to the fact that all modules 1, 3 could be produced and tested separately as a single device, possibility of potential problems/failures/scraps and thus resulting decrease of revenues or losses are minimized. Either output cable/connections 8 can come out of each module 1, 3 or the output connector 6 can be used in each module 1, 3 as an interface to subsequent interconnection/cabling 7 inside of the common frame 2. Output cable/connection 8 of each module 1, 3 can come out of the common frame 2, nevertheless advantage of this solution is seen when interconnection Inside of the common frame 2 is done and only one output cable 7, consisting of all signal wires 8 from each module 1, 3, is coming out as an interface to external devices.

Though in the embodiments shown in the Fig. 1 and 2 the common frames 2 are designed for embedding of three single-phase current and voltage measuring modules 1, in some applications it is not necessary to measure all three phases and thus the common frame 2 that can contain three single-phase current and voltage measuring modules 1 can be actually occupied by only one or two of them, the space for other single-phase current and voltage measuring modules 1 up to the number of three thus remaining vacant. On the other hand, in case it is necessary to measure more than three phases, a similar common frame (not shown) can be designed to seat more than three single-phase current and voltage measuring modules 1.

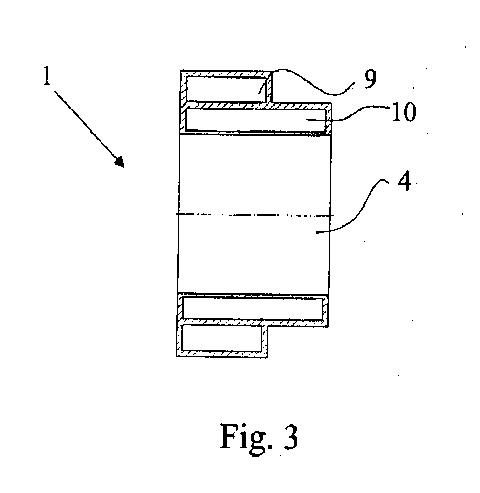

Figure 3 shows a section of a single-phase current and voltage measuring module 1 containing a space 9 for a single-phase current measuring sensor and a space 10 for a single-phase voltage measuring sensor. The single-phase current measuring sensor is in a form of a Rogowski coil as described above. Single-phase voltage measuring sensor preferably contains a resistive divider which may also need some shielding electrodes to shield said resistive divider and to provide proper electric field distribution. Another possibility is to make a single-phase voltage measuring sensor as a capacitive voltage divider. It is a use of resistive or capacitive voltage dividers for voltage measurements together with a use of Rogowski coils for current measurements that enables a production of small size single-phase current and voltage measuring modules 1. This combined unit may include also residual current detection device 3 inside the same common frame 2. Residual current detection device 3 may be placed around the single-phase current sensors or next to them. In both cases, all current sensing elements may be fixed together in order to simplify assembly process and amount of separate fixation points. Such unit can have again only one output connector 6, output cable 7 or just secondary terminals. Unit needs to be equipped with some fixation means. In order to reduce weight of the unit, a cavity can be introduced if space inside allows it.

In case a capacitive voltage divider is used, it needs a primary electrode to be connected to the high potential, i. e. to the measured voltage. In case the primary conductor is directly casted within the sensor body, this primary electrode can be avoided. Another part of capacitive voltage divider is capacitive electrode. This capacitive electrode can be fixed to the single-phase current sensor, but it needs an insulation in between in case that conductive or semiconductive layer is used for the single-phase current sensor. Such unit can have again only one output connector 6, but more of them can be used when needed. There could be also a cable or secondary terminals instead of the output connector 6. Unit needs to be equipped with some fixation means and with a place for primary conductor.

The combined electrical variable detection device can contain one or two single-phase current and voltage measuring modules 1 and two or one single-phase current measuring modules that are arranged in a common frame 2. Such device would contain three modules as in already described embodiments, but only one or two modules contain a voltage detection device.

The reason for placing all modules 1, 3 with devices for measuring single-phase current and voltage and residual-current into one body is the aim to reduce total volume occupied, production costs, necessary fixation and assembly work during installation and to provide a single current device measuring all currents needed for measurement and protection purposes. Another important new proposed feature is an assembly of these single-phase measurement units. The assembly can consist of three single-phase units/modules that could be produced and tested separately to reduce potential production losses and then placed/fixed in common frame 2. The same modules 1 could then be used for different frames respecting different applications or different phase distances needed.

The use of electronic instrument transformers enables such combination in case that no ferromagnetic material is used. Absence of ferromagnetic material should not limit the use of current sensors, e.g. Rogowski coils, when phase current and residual current measurements are combined together.

This invention thus proposes to use three modules 1, e.g. based on Rogowski coil principle, to be used in one common frame. Each module containing one Rogowski coll can be produced and tested separately thus decreasing the risk that some failure may be noticed after assembly into the common frame 2. Advantage of this solution is a possibility to use the same modules also for other phase distances without influencing module or coil design, only different common frame 2 would be in such case needed.

One can include also residual current measurement into this common frame. Furthermore, other measurements could be integrated as well (e.g. temperature, vibration, dust, humidity) in case that space allows it. There could be several output cables and/or terminals or connectors from each sensing element used as an interface of such combined device to other connected devices, nevertheless such combined solution/device enables the use of a single cable/connector containing all signal wires thus simplifying installation in a given application.

Residual voltage could be measured by means of voltage dividers, connected to all three phases of a three-phase system. If one connects outputs of these voltage dividers to open-delta connection, residual voltage could be measured there and it would show a possible asymmetry in the network caused e.g. by a ground fault. Residual voltage could be also measured by using only high impedances (either resistive and/or capacitive) connected separately to all three phases on one side, the other side of impedances from all three phases being interconnected. In this case, residual voltage could be measured between this interconnection point and ground. Best fit of given method/device for residual voltage measurement depends on system network design and Its grounding.

Combined electrical variable detection device, in the sense of this invention proposal, could integrate following functions:
- three single-phase current measurements and at least one single-phase voltage measurement consisting of three single-phase current and voltage measuring modules integrated into one common frame
- phase-currents and voltage measurements + residual current measurement phase-currents measurements + phase-voltage measurements + residual current measurement + temperature measurement
- phase-currents measurements + phase-voltage measurement + residual voltage measurement + temperature measurement + any other sensor available with present solutions
- phase-currents measurements + phase-voltage measurements + residual current and voltage measurement + temperature measurement + any other sensor available with present solutions

The introduced inventive solution could be used mainly with electronic instrument transformers which do not contain any ferromagnetic materials, nevertheless their use could be allowed in case of satisfactory shielding of magnetic field around these parts, when having appropriate shape of such parts or in case that internal construction is done in such a way, that the internal influences are minimized.

In case of electronic voltage transformers the residual voltage information could be obtained either from calculation of the phase-voltage measurements or it can be made by using voltage dividers of any of the mentioned types.

## Claims

1. Combined electrical variable detection device, comprising a number of single-phase current measuring modules (1) arranged in a common frame (2), having a separate output cable/connection (8) for each module (1), **characterized in that** at least one single-phase current measuring module (1) is provided with a voltage detection device, the combined electrical variable detection device using one output cable/connection (7), the signal wires of which are coupled to said output cable/connections (8) from said modules (1).

2. Combined electrical variable detection device according to claim 1, **characterized in that** all single-phase current measuring modules (1) are provided with Rogowski coils as measuring elements.

3. Combined electrical variable detection device according to claim 1, **characterized in that** all single-phase current measuring modules (1) are provided with a voltage detection device.

4. Combined electrical variable detection device according to claim 1. **characterized in that** it is provided with a residual-current detection device (3) surrounding more than one of said single-phase current measuring modules (1) in said common frame (2).

5. Combined electrical variable detection device according to claim 1, **characterized In that** it combines three phase-current measuring modules (1), each of which is provided with the corresponding phase-voltage detection device, all phase-current measuring modules (1)and phase-voltage detection devices being placed together with a residual-current detection device (3) in said common frame (2) and all the devices and modules (1) being positioned close to each other.

6. Combined electrical variable detection device according to claim 1, **characterized in that** at least one of the phase-current measuring modules (1) is/are fixed in said common frame (2), said common frame (2) being designed for embedding of more phase-current measuring modules (1) than the number that is/are actually fixed.

7. Combined electrical variable detection device according to claim 6, **characterized in that** voltage detection devices contain resistive or capacitive dividers for voltage detection.

8. Combined electrical variable detection device according to claim 6, **characterized in that** it further contains other sensing elements as a temperature measuring device (5).

9. Combined electrical variable detection device according to claim 6, **characterized in that** it is provided with a residual-voltage detection device.
